# EUROPEAN PATENT SPECIFICATION

(11) **EP 0 417 933 B1**
(45) Date of publication and mention of the grant of the patent: **20.07.1994**
(21) Application number: 90309442.3
(22) Date of filing: 29.08.1990
(51) Int. Cl.: G01R 19/165, H05B 39/04

(54) **Circuits for detecting a decrease in the voltage of a DC source**
Detektionsschaltung für den Spannungsabfall einer Gleichstromquelle
Circuits pour détecter une diminution de tension d'une source de courant continu

(30) Priority: 11.09.1989 JP 235299/89
(43) Date of publication of application: 20.03.1991
(73) Proprietor: SONY CORPORATION, Tokyo 141 (JP)
(72) Inventor: Maruichi, Takanori, c/o Patents Division, Shinagawa-ku Tokyo 141 (JP)
(74) Representative: Thomas, Christopher Hugo

(56) References cited:
- DE-A- 2 918 960
- US-A- 3 863 128
- US-A- 4 412 156

## Description

This invention relates to circuits for detecting a decrease in the voltage of a DC source, such as a battery.

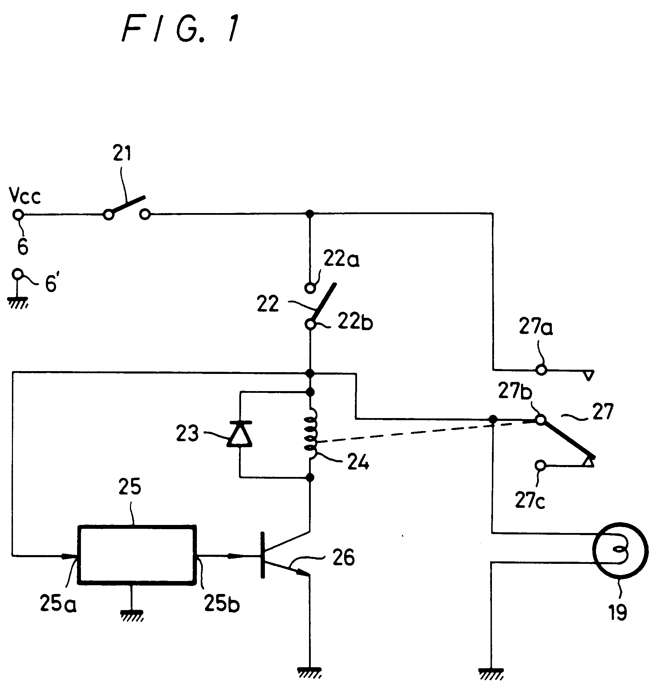

Figure 1 shows a circuit for energizing metal halide lamp such as used with a camera. A DC voltage Vcc is supplied across voltage source terminals 6 and 6′. The DC voltage source might comprise a secondary battery of the camera, such as a nickel-cadium battery or the like. The DC voltage Vcc is consumed by the lamp, so that the fluctuation in voltage at the terminal 6 is relatively large.

The voltage across the terminals 6 and 6′ is supplied through a power switch 21 to a fixed contact 22a of a switch 22 and to a closed or make contact 27a of a relay 27. A movable contact 22b of the switch 22 is electrically connected to a movable contact 27b of the relay 27, to one end of a relay drive coil 24, to the cathode of a reverse current blocking diode 23, and to an input terminal 25a of an integrated circuit (IC) that operates as a voltage detecting circuit 25. The voltage detecting circuit 25 supplies a high-level signal at an output terminal 25b thereof when the DC voltage Vcc applied to the input terminal 25a is higher than a predetermined voltage level, and supplies a low level signal at the output terminal 25b when the DC voltage Vcc is lower than the predetermined voltage level.

The output terminal 25b of the voltage detecting circuit 25 is connected to the base of a switching transistor 26, whose collector is connected to the anode of the diode 23 and to the other end of the relay drive coil 24. The emitter of the transistor 26 is earthed, and the movable contact 27b of the relay 27 is connected to one side of a metal halide lamp 19 that comprises the load in the circuit. The other contact 27c of the relay 27 is the open or break contact.

In operation, if the lamp 19 is to be turned ON the power switch 21 is closed and the switch 22 is manually depressed to the closed state. The switch 22 is ON or closed only so long as it remains manually depressed. At that time, the magnitude of the DC voltage Vcc supplied from the DC voltage source to the input terminal 25a of the voltage detecting circuit 25 is detected. If the detected voltage falls within a predetermined voltage range, the voltage detecting circuit 25 generates a high-level voltage at the output terminal 25b, thereby biasing the base of the switching transistor 26 so that it is turned ON. Thus, the relay drive coil 24 is excited by the DC voltage Vcc and the movable contact 27b resting on the break contact 27c is moved into contact with the make contact 27a, whereby the DC voltage Vcc from the voltage source terminal 6 is supplied to the lamp 19. Therefore, the lamp 19 is turned ON, and a current flows through the relay drive coil 24 causing the relay 27 to keep itself pulled in.

In this condition, if the DC voltage Vcc from the DC voltage source decreases to the predetermined, minimum acceptable value, a low-level voltage will be developed at the output terminal 25b of the voltage detecting circuit 25, whereby the switching transistor 26 is turned OFF and the current flowing through the relay drive coil 24 is interrupted. Thus, the movable contact 27b of the relay 27 will return to the break contact 27c and the relay 27 will be turned OFF. If the relay 27 is released from the pulled in state, the power to the lamp 19 is interrupted, which is the same as the power switch 21 being turned OFF.

With this arrangement, the lamp 19 must be turned ON and OFF by use of manual switch 22, and the voltage detecting circuit 25 for detecting whether the voltage of the DC voltage source has fallen below a predetermined value must be formed of an integrated circuit, which results in an expensive control circuit. Furthermore, the relay 27 must be controlled, which results in a control circuit that consumes more power than is desirable.

According to the present invention there is provided a circuit for detecting a decrease in the voltage level of a DC voltage source supplying current to a load and receiving a load control signal, the circuit comprising:
a first transistor of a first polarity having said control signal supplied to the base thereof, the collector of said first transistor being connected to one terminal of said DC voltage source, the emitter of said first transistor being connected through a capacitor to the base of a second transistor of said first polarity, the base of said second transistor being connected through a first resistor to the other terminal of said DC voltage source, the collector of said second transistor being connected to the base of a third transistor of a second polarity, the emitter of said third transistor being connected to said one terminal of said DC voltage source, the collector of said third transistor being connected through a series circuit of a second resistor and a reference voltage device to said other terminal of said DC voltage source, a junction between said second resistor and said reference voltage device being connected to the base of a fourth transistor of said first polarity, the collector of said fourth transistor being connected through a third resistor to the collector of said third transistor, the collector of said fourth transistor being connected through a fourth resistor to the base of said second transistor, the emitters of said second and fourth transistors being coupled together, and a junction therebetween being connected through a fifth resistor to said other terminal of said DC voltage source; wherein the supply of current to said load is controlled by said third transistor, said third transistor being turned ON or OFF by the control signal, and said third transistor being turned OFF when a voltage between said two terminals of said DC voltage source becomes lower than a predetermined voltage determined by said reference voltage device.

According to the present invention there is also provided a circuit for detecting the discharge level of a battery, wherein a control signal is supplied to the base of a first transistor whose collector is connected to one electrode of a DC voltage source and whose emitter is connected through a capacitor to the base of a second transistor of the same polarity. The base of the second transistor is connected through a first resistor to the other electrode of the DC voltage source, and the collector of the second transistor is connected to the base of a third transistor of opposite polarity, whose emitter is also connected to one electrode of the DC voltage source. The collector of the third transistor is connected through a series circuit of a second resistor and a reference voltage source to the other electrode of the DC voltage source. A junction between the second resistor and the reference voltage source is connected to the base of a fourth transistor of the same polarity as the first and second transistors, and the collector of the fourth transistor is connected through a third resistor to the collector of the third transistor. The collector of the fourth transistor is also connected through a fourth resistor to the base of the second transistor. The emitters of the second and fourth transistors are coupled together, and a junction therebetween is connected through a fifth resistor to the other electrode of the DC voltage source In this circuit, the supply of current to a load is controlled by the third transistor, which is turned ON or OFF by a control signal supplied to its control signal input terminal. The third transistor is turned OFF when a voltage across the two electrodes of the DC voltage source becomes lower than a predetermined acceptable voltage, which is determined by the reference voltage source.

The invention will now be described by way of example with reference to the accompanying drawings, throughout which like parts are referred to by like references, and in which:
Figure 1 is a schematic diagram showing an example of a previously proposed control circuit for a load; and
Figures 2 and 3 are schematic diagrams of first and second embodiments of a circuit for detecting the discharge level of a battery, and according to the present invention.

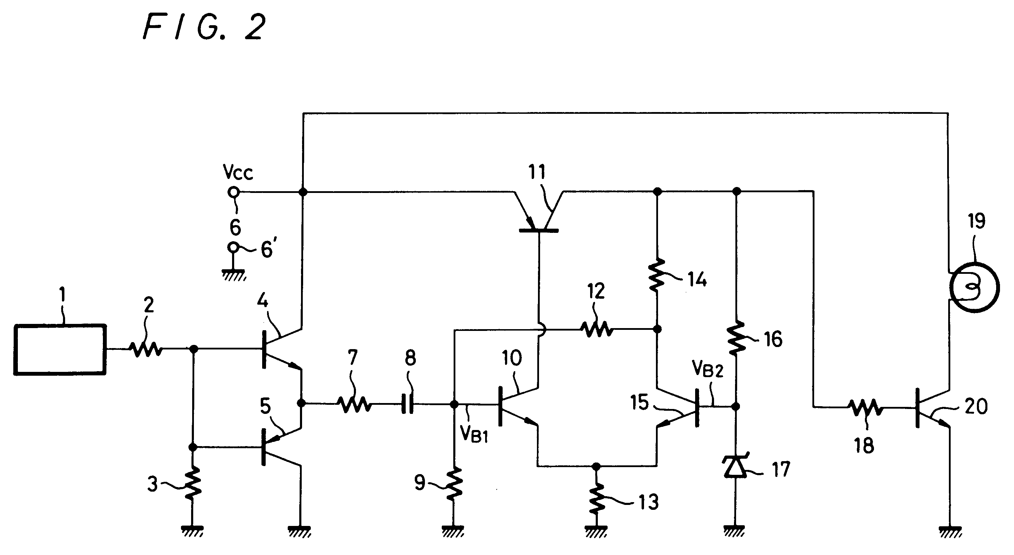

In the embodiment of Figure 2, the control circuit is used to control a metal halide lamp so that the lamp is properly turned ON and OFF. More particulary, the control circuit is used to control an illumination lamp or the like that is attached, for example, to a small-size video camera driven by a secondary battery.

Referring to Figure 2, a microcomputer comprises a control apparatus for the camera, and this microcomputer is more aptly referred to as a central processing unit (CPU) 1. A control signal from the CPU 1 is supplied through a resistor 2 to the bases of npn and pnp transistors 4 and 5, respectively. A junction between the base of the pnp transistor 5 and the resistor 2 is earthed via a resistor 3. The collector of the npn transistor 4 is connected to a voltage source terminal 6 to which a DC voltage Vcc is applied, with a terminal 6′ being connected to the other side of the DC voltage source.

The emitter of the npn transistor 4 and the emitter of the pnp transistor 5 are coupled together, and the collector of the pnp transistor 5 is earthed. The junction of the emitter of the npn transistor 4 and the emitter of the pnp transistor 5 is connected to the base of an npn transistor 10 via a series circuit comprising a resistor 7 and a capacitor 8. The collector of the npn transistor 10 is connected to the base of a pnp transistor 11, and the emitter of the npn transistor 10 is coupled to the emitter of an npn transistor 15. The junction between the emitters of the npn transistors 10 and 15 is earthed via a resistor 13. The emitter of the pnp transistor 11 is connected to the voltage source terminal 6, to which the DC voltage Vcc is applied. The collector of the pnp transistor 11 is connected through a resistor 18 to the base of an npn transistor 20. The collector of the npn transistor 15 is connected through a resistor 14 to the collector of the pnp transistor 11 and through a resistor 12 to the base of the npn transistor 10. The base of the npn transistor 10 is earthed via a resistor 9. The base of the npn transistor 15 is connected through a resistor 16 to the collector of the pnp transistor 11 and through a Zener diode 17 to earth. The Zener voltage of the Zener diode 17 comprises the reference voltage that is selected to be such that when the DC voltage Vcc at the voltage source terminal 6 is lower than a predetermined voltage, the transistor 15 is turned ON. The collector of the npn transistor 20 is connected to one terminal of a metal halide lamp 19 and the other terminal of the lamp 19 is connected to the voltage source terminal 6. The emitter of the npn transistor 20 is earthed.

In operation of the control circuit of Figure 2, when an operation signal consisting of a positive polarity pulse from the CPU 1 is supplied through the resistor 2, the base of the npn transistor 4 is biased so that the DC voltage Vcc is applied from the voltage source terminal 6 through the resistor 7 and the capacitor 8 to the base of the npn transistor 10. Therefore, a voltage V_{B1} at the base of the npn transistor 10 goes to a higher level and the npn transistor 10 is turned ON. The collector voltage of the npn transistor 10 makes the base voltage of the pnp transistor 11 lower in level than before the transistor 10 was turned ON, and the pnp transistor 11 is then also turned ON. As a result, a self-holding circuit is formed by a loop of the emitter and collector of the pnp transistor 11, the resistor 14, the resistor 12 and the base of the npn transistor 10, whereby the ON-state of the npn transistor 10 is maintained. Accordingly, the ON-state of the pnp transistor 11 is maintained so that the DC voltage Vcc at the voltage source terminal 6 is supplied through the pnp transistor 11 and the base resistor 18 to the base of the npn transistor 20, whereby the npn transistor 20 is turned ON. The transistors 4 and 5 act as a buffer circuit.

Therefore, the DC voltage Vcc from the voltage source terminal 6 is supplied to the lamp 19 via a loop formed of the lamp 19, the collector and emitter of the npn transistor 20, the earth return, and the DC voltage source, in that order, whereby the lamp 19 is turned ON. In this state, a base voltage V_{B2} of the npn transistor 15 is smaller than the base voltage V_{B1} of the npn transistor 10, such that an inequality of V_{B1} > V_{B2} is established, and the result is that the circuit is in a stable condition.

When an operation signal comprising a negative polarity pulse from the CPU 1 is supplied through the resistor 2 as a control signal, the npn transistor 10 is turned OFF via npn and the pnp transistors 4 and 5 forming the buffer circuit, so that the pnp transistor 11 is also turned OFF. This results in the npn transistor 20 being turned OFF to prevent the voltage Vcc of the voltage source terminal 6 from being supplied to the lamp 19, thus the load is blocked from its voltage source.

When the DC voltage Vcc from a voltage source, such as the secondary battery or the like, as applied to the voltage source terminal 6 becomes lower than the predetermined voltage level because of the discharge of the battery, the base potential or voltage V_{B2} of the npn transistor 15, as determined by the Zener diode 17, becomes larger than the base potential or voltage V_{B1}, resulting in V_{B1} < V_{B2}. This has the effect that the npn transistor 10 is turned OFF, while the voltage of the npn transistor 15 is maintained as the potential of the reference voltage source 17 and the npn transistor 15 is turned ON.

More specifically, the base voltage of the npn transistor 10 is applied through the resistor 12 to the collector of the npn transistor 15 so that, when V_{B1} = V_{B2}, the base potential V_{B1} of the npn transistor 10 is lowered with increasing speed and the npn transistor 10 is immediately turned OFF. Consequently, the pnp transistor 11 is also turned OFF and the npn transistor 20 is turned OFF, thereby inhibiting the supply of the voltage Vcc to the lamp 19.

In this circuit arrangement, the npn transistor 5 might be thought of as a switching transistor that discharges voltages accumulated in the capacitor 8 when the DC voltage Vcc of the voltage source terminal 6 is disconnected or when the operation signal in the form of a negative polarity pulse is supplied from the CPU 1.

Thus, in this embodiment, the lamp 19 can be turned ON and OFF by a very low power pulse signal from the CPU 1 and a voltage drop of the DC voltage Vcc supplied at the voltage source terminal 6 can be detected, thereby quickly interrupting the supply of the voltage to the lamp 19 forming the load without requiring a relay.

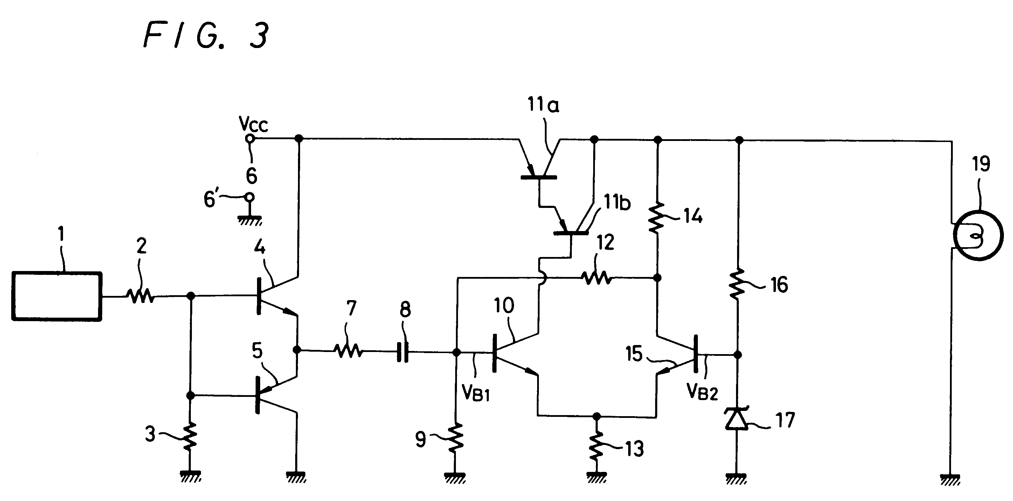

In the embodiment of Figure 3, the metal halide lamp 19 is again provided as the load but is directly driven without the additional transistor provided in the embodiment of Figure 2.

In Figure 3, the pnp transistor (11) that was provided in the embodiment of Figure 2 is replaced by two transistors 11a and 11b, which are Darlington-connected. The emitter of the transistor 11a is connected to the voltage source terminal 6, and the collector of the transistor 11a and the collector of the transistor 11b are connected together to one terminal of the lamp 19. The other terminal of the lamp 19 is earthed, as is the other terminal 6′ to which the DC voltage source is connected. The emitter of the transistor 11b is connected to the base of the transistor 11a, and the base of the transistor 11b is connected to the collector of the npn transistor 10, in Darlington configuration. The remaining circuit elements in the embodiment of Figure 3 are the same as these of Figure 2.

In this second embodiment of Figure 3, when the npn transistor 10 is turned ON, the Darlington-connected transistors 11a and 11b are turned ON, whereby the DC voltage Vcc applied to the voltage source terminal 6 is directly supplied to the load, that is, to the lamp 19. Therefore, the ON and OFF state of the load circuit can be directly controlled by a low-power control signal, such as might be provided by a microcomputer or the CPU 1.

Although a metal halide lamp is shown as the load in the above embodiments, it can be replaced with other loads, such as a resistor, a motor, or the like.

With embodiments of the present invention for detecting an excessive discharge of a battery, and an attendant decrease in voltage, the load is not controlled by the operation of a relay and the load can be controlled solely by a low-power control signal from a CPU or the like. Moreover, a detecting circuit based on an expensive IC is not required to detect a drop in the DC voltage level, and fluctuations of such DC voltage can be automatically detected by a relatively simple circuit.

## Claims

1. A circuit for detecting a decrease in the voltage level of a DC voltage source supplying current to a load (19) and receiving a load control signal, characterized in that the circuit comprises:
a first transistor (4) of a first polarity having said control signal supplied to the base thereof, the collector of said first transistor (4) being connected to one terminal (6) of said DC voltage source, the emitter of said first transistor (4) being connected through a capacitor (8) to the base of a second transistor (10) of said first polarity, the base of said second transistor (10) being connected through a first resistor (9) to the other terminal (6′) of said DC voltage source, the collector of said second transistor (10) being connected to the base of a third transistor (11) of a second polarity, the emitter of said third transistor (11) being connected to said one terminal (6) of said DC voltage source, the collector of said third transistor (11) being connected through a series circuit of a second resistor (16) and a reference voltage device (17) to said other terminal (6′) of said DC voltage source, a junction between said second resistor (16) and said reference voltage device (17) being connected to the base of a fourth transistor (15) of said first polarity, the collector of said fourth transistor (15) being connected through a third resistor (14) to the collector of said third transistor (11), the collector of said fourth transistor (15) being connected through a fourth resistor (12) to the base of said second transistor (10), the emitters of said second and fourth transistors (10, 14) being coupled together, and a junction therebetween being connected through a fifth resistor (13) to said other terminal (6′) of said DC voltage source;
wherein the supply of current to said load (19) is controlled by said third transistor (11), said third transistor (11) being turned ON or OFF by the control signal, and said third transistor (11) being turned OFF when a voltage between said two terminals (6, 6′) of said DC voltage source becomes lower than a predetermined voltage determined by said reference voltage device (17).

2. A circuit according to claim 1 wherein said reference voltage device (17) is a Zener diode (17).

3. A circuit according to claim 1 as claim 2 wherein said load (19) is a metal halide lamp (19).

4. A circuit according to claim 1, claim 2 or claim 3 wherein said third transistor is a transistor (11b) or a Darlington-connected pair of transistors (11a, 11b) and in which the emitter of said third transistor (11b) is connected to said one terminal (6) of said DC voltage source through a base-emitter path of a sixth transistor (11a) forming the other transistor of said Darlington-connected pair.

5. A circuit according to any one of the preceding claims wherein a seventh transistor (5) whose collector is earthed and whose base is supplied with said control signal is connected at its emitter to the emitter of said first transistor (4), thereby selectively to discharge said capacitor (8).

## Patentansprüche

1. Schaltung zur Ermittlung einer Abnahme des Spannungspegels einer Gleichspannungsquelle, die Strom zu einer Last (19) liefert und ein Laststeuersignal empfängt,
**dadurch gekennzeichnet,** daß die Schaltung aufweist:
einen ersten Transistor (4) einer ersten Polarität, an dessen Basis das Steuersignal geliefert wird, wobei der Kollektor des ersten Transistors (4) mit einem Anschluß (6) der Gleichspannungsquelle verbunden ist, wobei der Emitter des ersten Transistors (4) über einen Kondensator (8) mit der Basis eines zweiten Transistors (10) der ersten Polarität verbunden ist, wobei die Basis des zweiten Transistors (10) über einen ersten Widerstand (9) mit dem anderen Anschluß (6') der Gleichspannungsquelle verbunden ist, wobei der Kollektor des zweiten Transistors (10) mit der Basis eines dritten Transistors (11) einer zweiten Polarität verbunden ist, wobei der Emitter des dritten Transistors (11) mit dem einen Anschluß (6) der Gleichspannungsquelle verbunden ist, wobei der Kollektor des dritten Transistors (11) über eine Reihenschaltung aus einem zweiten Widerstand (16) und einer Referenzspannungseinrichtung (17) mit dem anderen Anschluß (6') der Gleichspannungsquelle verbunden ist, wobei ein Verbindungspunkt zwischen dem zweiten Widerstand (16) und der Referenzspannungseinrichtung (17) mit der Basis eines vierten Transistors (15) der ersten Polarität verbunden ist, wobei der Kollektor des vierten Transistors (15) über einen dritten Widerstand (14) mit dem Kollektor des dritten Widerstands (11) verbunden ist, wobei der Kollektor des vierten Transistors (15) über einen vierten Widerstand (12) mit der Basis des zweiten Widerstands (10) verbunden ist, wobei die Emitter der zweiten und vierten Transistoren (10, 14) miteinander gekoppelt sind, und wobei ein dazwischen liegender Verbindungspunkt über einen fünften Widerstand (13) mit dem anderen Anschluß (6') der Gleichspannungsquelle verbunden ist,
wobei die Stromlieferung zur Last (19) durch den dritten Transistor (11) gesteuert wird, wobei der dritte Transistor (11) durch das Steuersignal eingeschaltet oder ausgeschaltet wird, und wobei der dritte Transistor (11) ausgeschaltet wird, wenn eine Spannung zwischen den beiden Anschlüssen (6, 6') der Gleichspannungsquelle niedriger als eine durch die Referenzspannungseinrichtung (17) vorgegebene Spannung wird.

2. Schaltung nach Anspruch 1, wobei die Referenzspannungseinrichtung (17) durch eine Zenerdiode (17) gebildet wird.

3. Schaltung nach Anspruch 1 und 2, wobei die Last (19) eine Halogenmetalldampflampe (19) ist.

4. Schaltung nach Anspruch 1, 2 oder 3, wobei der dritte Transistor durch einen Transistor (11b) oder durch zwei über eine Darlington-Schaltung verbundene Transistoren (11a, 11b) gebildet ist, und bei der der Emitter des Transistors (11b) mit dem einen Anschluß (6) der Gleichspannungsquelle über einen Basis-Emitterpfad eines sechsten Transistors (11a) verbunden ist, der den anderen Transistor des darlingtonverbundenen Paars bildet.

5. Schaltung nach einem der vorhergehenden Ansprüche, wobei ein siebter Transistor (5), dessen Kollektor geerdet ist und dessen Basis mit dem Steuersignal beliefert wird, mit seinem Emitter mit dem Emitter des ersten Transistors (4) verbunden ist, so daß der Kondensator (8) wahlweise entladen werden kann.

## Revendications

1. Circuit pour détecter une diminution du niveau de tension d'une source de tension de courant continu fournissant un courant à une charge (19) et recevant un signal de commande de charge, caractérisé en ce que le circuit comprend :
un premier transistor (4) d'une première polarité ayant ledit signal de commande appliqué à la base de celui-ci, le collecteur dudit premier transistor (4) étant relié à une borne (6) de ladite source de tension de courant continu, l'émetteur dudit premier transistor (4) étant relié via un condensateur (8) à la base d'un second transistor (10) de ladite première polarité, la base dudit second transistor (10) étant reliée via une première résistance (9) à l'autre borne (6') de ladite source de tension de courant continu, le collecteur dudit second transistor (10) étant relié à la base d'un troisième transistor (11) d'une seconde polarité, l'émetteur dudit troisième transistor (11) étant relié à ladite borne (6) de ladite source de tension de courant continu, le collecteur dudit troisième transistor (11) étant relié via un circuit en série formé d'une seconde résistance (16) et un dispositif de tension de référence (17) à ladite autre borne (6') de ladite source de tension de courant continu, une jonction entre ladite seconde résistance (16) et ledit dispositif de tension de référence (17) étant relié à la base d'un quatrième transistor (15) de ladite première polarité, le collecteur dudit quatrième transistor (15) étant relié via une troisième résistance (14) au collecteur dudit troisième transistor (11), le collecteur dudit quatrième transistor (15) étant relié via une quatrième résistance (12) à la base dudit second transistor (10), les émetteurs desdits second et quatrième transistors (10, 14) étant couplés ensemble, et une jonction entreeux étant reliée via une cinquième résistance (13) à ladite autre borne (6') de ladite source de tension de courant continu ;
dans lequel la fourniture du courant à ladite charge (19) est commandée par ledit troisième transistor (11), ledit troisième transistor (11) étant conducteur ou bloqué par le signal de commande, et ledit troisième transistor (11) étant bloqué lorsqu'une tension entre lesdites deux bornes (6, 6') de ladite source de tension de courant continu devient inférieure à une tension prédéterminée déterminée par ledit dispositif de tension de référence (17).

2. Circuit selon la revendication 1 dans lequel ledit dispositif de tension de référence (17) est une diode Zener (17).

3. Circuit selon la revendication 1 et la revendication 2 dans lequel ladite charge (19) est une lampe à halogénure métallique (19).

4. Circuit selon la revendication 1, la revendication 2 ou la revendication 3 dans lequel ledit troisième transistor est un transistor (11b) ou une paire de transistors montés en Darlington (11a, 11b) et dans lequel l'émetteur dudit troisième transistor (11b) est relié à ladite borne (6) de ladite source de tension de courant continu via un chemin base-émetteur d'un sixième transistor (11a) formant l'autre transistor de ladite paire montée en Darlington.

5. Circuit selon l'une quelconque des précédentes revendications dans lequel un septième transistor (5) dont un collecteur est à la masse et dont une base reçoit ledit signal de commande, est relié par son émetteur à l'émetteur dudit premier transistor (4), pour ainsi décharger sélectivement ledit condensateur (8).
